(19)

Europäisches
Patentamt
European
Patent Office
Office européen
des brevets

(11) **EP 2 209 046 A1**

(12) **EUROPEAN PATENT APPLICATION**

(43) Date of publication:
**21.07.2010 Bulletin 2010/29**

(21) Application number: **09000560.4**

(22) Date of filing: **16.01.2009**

(51) Int Cl.:
***G03F 1/00*** *(2006.01)*  ***G03F 1/14*** *(2006.01)*
***G03F 7/00*** *(2006.01)*

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(71) Applicant: **Pixer Technology Ltd.**
**21613 Karmiel (IL)**

(72) Inventors:
• **Dmitriev, Vladimir**
  **Camiel 21721 (IL)**

• **Ben Zvi, Guy**
  **Misgav 20183 (IL)**
• **Graitzer, Erez**
  **Misgav 20103 (IL)**

(74) Representative: **Müller, Utz**
**Carl Zeiss AG**
**Standort Jena**
**Carl-Zeiss-Promenade 10**
**07745 Jena (DE)**

(54) **Method and apparatus for registration correction of masks**

(57)    A method for correcting registration errors of a mask, the mask comprising a surface and structural elements forming a pattern located on the surface, the method comprising: measuring the registration errors of the structural elements partitioning the mask in arbitrary elements determining for each element a writing mode and a density of pixels for minimization of the registration errors, writing the determined pixels for correcting the registration error. Different writing modes means writing with different physical conditions resulting in different kinds of pixels with different properties.

EP 2 209 046 A1

**Description**

This invention relates to a method for correcting registration errors of a mask, the mask comprising a surface and structural elements forming a pattern located on the surface, the method comprising: measuring the registration errors of the structural elements and determining pixels (density changes) to correct the registration error and writing the determined pixels.

The invention further concerns an apparatus to perform the method mentioned above.

Registration measurement apparatuses measure the position of auxiliary marks (typically crosses) or of certain structural elements forming a pattern located on a mask or reticle relative to an ideal imaginary Cartesian grid. The mask is arranged on a two-dimensional shifting unit, which positions the mark to be measured relative to the observation system. The observation system usually consists of an illuminator, imaging optics (e. g. a microscope) as well as a camera. The position of the mark is calculated from the position of the shifting unit and the location of the image on the camera. The registration of the entire mask is defined after each mark has been successively measured. The deviation from the registration as it should be from the measured registration is called the registration error.

If registration errors exceed a certain amount the mask can not be used for the lithographic process in the waver fabs. Since the production of a mask is very expensive, it is desirable to correct the registration errors.

It is known in the prior art to correct registration errors introducing elements in the bulk material of the mask causing density changes. These density changes are resulting in a lateral movement of structural elements. Those elements causing density changes are called pixels.

The German patent application DE 102006054820 which is incorporated by reference discloses a method of writing pixels to correct registration errors and transmission of the mask at the same time. Each registration error is corrected by writing pixels in a certain area of the mask. Different Pixel densities or Pixels of different shapes or locations can be used to reach the desired correction. The problem of changing registration and transmission at the same time when writing Pixels in the patterned area of the mask is addressed. A relation between transmission change and registration change writing pixels of different size and varying the pixel density (the number of pixels per area) is disclosed. It is disclosed to collect the behavior of different combinations of Pixels in a library. So a certain correction of registration and transmission can be performed by choosing the right set of parameters for writing from the library.

The US patent application US2008/032206 which is incorporated by reference discloses the same way of correcting registration errors writing pixels in the bulk of a mask. The problem of changing registration and transmission at the same time when writing Pixels is not addressed here.

The pixels used for registration correction are known to be used for the correction of critical dimensions (CD) variations of masks as disclosed e. g. in the European patent application EP 1649323 which is incorporated by reference. The reduction of the transmission as defined there is called attenuation. An apparatus used for writing pixels is disclosed here.

In the cited prior art the registration errors are corrected by writing certain pixels corresponding to a specific registration error. In the cited US2008/032206 the interaction of the corrections of different registration errors is not addressed. In the cited DE 102006054820 the registration errors are corrected independently from each other and an optimization of the whole mask follows in an iterative process. Calculating a map of pixel density to be written for registration correction using finite element calculations is addressed but not disclosed in detail.

So the problem is to provide an improved method for correcting registration errors overcoming the drawbacks of the prior art.

This problem is solved by a method according to claim 1. Further embodiments are given in the dependent claims.

To correct registration errors of a mask different kinds of pixels are used. So it is possible to adjust the relation of attenuation (transmission) and registration introduced in the mask by writing a certain kind of pixels. For example it is possible to write pixels of different kinds introducing the same attenuation but different registration change.

In general pixels introduce stress into the material of the mask by changing the density of the material. Expanding pixels and contracting pixels are known. Writing expanding pixels the density of the mask material is reduced, writing contracting pixels the density of the mask material is increased. It is possible to write contracting pixels using different pulse duration/energy. Actually by shooting with the laser with energy density above a threshold we initiate optical breakdown that generates plasma inside the bulk of the material. Generation of plasma and cooling down are complex physical phenomena that develop differently at different excitation energy. One have to take into account crystallization of the material that is connected to backward acoustic wave when different atoms and ions behave differently. As a result of that process some variation of density from the center of breakdown to the outside of affected area is to be expected. Often this variation has an oscillation profile and it is important which phase of oscillation occurs at the periphery of an affected area.

Different modes of writing are defined as the writing with different physical conditions resulting in different kinds of pixels with different properties and/or different shapes.

Different modes of the writing can be performed by changing one or more of the following parameters:

The laser pulse power to change the size of the pixels. Resulting pixel is smaller, so one has to compensate with pixel density. Small pixels with the same optical density result in smaller registration change. Actually minimum pulse energy is limited by breakdown threshold. By varying of the pulse duration, NA of the beam/ beam divergence and amount pulses to one location one can control breakdown threshold and hence decrease possible pulse energy.

The beam polarization. This allows to control pixel shape. Change of the pixel shape is not measured directly, but observed by change of the pixel light scattering. It also affects registration change.

Writing with different laser beam astigmatism. Using a laser beam with astigmatism affects the pixel shape. Change of pixel expansion ratio parallel to the surface of the mask (i. e. x/y ratio) results in different registration change in different lateral directions parallel to the surface of the mask (x and y directions).

In a further writing mode pixel are written with different linear pixel density in different XY direction, i. e. two perpendicular directions parallel to the surface of the mask. Different linear pixel density in different directions can result in nonsymmetrical element expansion that can give us an easy tool for registration control.

In a further writing mode pixels overlapping with each other are written, preferably a very low laser pulse power is used. Then a quasi continuous structure is written. The advantage is that those pixels does not cause any registration change but transmission change only. In a further variation pixel overlap only in one direction parallel to the surface. Overlapping pixels resemble more some layer in the bulk of the material with different physical properties. If this layer is homogeneous enough it affects less UV beam properties, there is no scattering and it does not introduce any artificial periodicity and hence does not generate any diffraction.

To correct the registration errors the writing modes and the pixel densities for the whole mask has to be determined. To perform further calculations the surface of the mask is partitioned in arbitrary elements. Within one element the same writing mode and the same density of pixels is applied.

The direct problem would be to compute the resulting deformation i. e. registration change as a function of writing mode and pixel density. To determine the registration correction to be applied the inverse problem is to be solved. This problem is to compute a map of writing modes and writing densities that gives the desired change of the registration and attenuation.

Mask is made of a very rigid material. Deformations we are speaking about are very small in amplitude and do not exceed elastic limit. One can consider three groups of equations: static equations, geometrical equations, physical equations. In Static equations state equilibrium of surface forces, bulk forces and stresses acting at any elementary element of the mask - static Newton's law. By utilization of Cauchy formulas (geometrical equations) one can derive strain tensor form displacement field. Not every strain field can result from a displacement field so one has to consider compatibility conditions. And in adiabatic approximation in thermally equilibrium state generalized Hooke's law (physical equations) states that for elastic body there is linear connection between strain and stress tensors.

All the mask body can be described as a system of the rectangular areas - elements where every area - element has constant mode and uniform density of writing. Every element can be characterized by new equilibrium shape and new physical parameters as Young's modulus, Poisson's ratio ... where all the changes with good approximation are proportional to writing load.

To compute the resulting displacement field as a function of writing mode and pixel density (i. e. the direct problem) one can utilize one of the next approaches (there are some more approaches such as Euler's):

1. to compute strain field that equalize all the internal forces/stresses acting at elements boundaries

2. to compute strain field by finding minimum of potential energy for all the mask body

Both approaches give linear dependence of displacements on writing amplitudes at given distribution of writing modes. This allows computing registration knowing writing densities and writing modes.

The inverse problem can be formulated in a general case. One have to find writing mode and density maps that give target displacement field. In general a writing mode is a discreet parameter and this problem has to be formulated as optimization problem. A target functional has to be constructed that has minimum (supremum) at the desired displacement field. Optimal writing and density maps have to give the displacement field that minimizes target functional.

Possible ways to solve the inverse problem to compute a map of writing modes and writing densities that gives the desired change of the registration and attenuation are:

1. Optimization of writing densities can be performed using MLS approach, but complete enumeration of discreet writing mode map can be very heavy in case of small element size.

2. Discreet parameter of mode map can be converted to continuous analog in assumption that one element can have superposition of the different writing modes. In the case all the element physical and shape properties changes are proportional to the contribution of the corresponding writing modes and the target functional is a square of residual deficiency. The variational formalism will result in a linear problem.

To demonstrate this a fruitful approximation will be used. In most of the cases when one can neglect mask bending phenomenon and modification of mask thickness the 3dimensional (3D) problem can be formulated in 2dimensions (2D). Every rectangular element will represent a rectangular parallelepiped of the mask.

As an approximation, the volume occupied by pixels is considered to be negligible and pixels are considered not to affect significantly 2D rigidity of the mask body.

An ideal (but not the only) way to realize this approach is performing finite element analysis. Without loss of generality we can present all the mask as a M*M set or matrix of square elements with the same size.

Let us introduce infinitesimal strain tensor $\varepsilon(x, y)$ with components $\varepsilon_{ij}(x, y)$ and stress tensor $\sigma(x,y)$ with components $\sigma_{ij}(x, y)$(1.).

Generalized Hooke's low ( linear elasticity ) can be presented as

$$\sigma_{ij}(x,y) = \sum_{kl} H_{ijkl}\varepsilon_{kl}(x,y) \qquad (1)$$

In 2D approximation we assume that there are no external forces acting to the surface of the mask tangential and normal to the mask surface.

$$\sigma_{zx} = \sigma_{xz} = 0$$
$$\sigma_{zy} = \sigma_{yz} = 0 \qquad (2)$$
$$\sigma_{zz} = 0$$

Shear components $\varepsilon_{zx}, \varepsilon_{xz}, \varepsilon_{zy}, \varepsilon_{yz}$ of a strain in the case of isotropic elasticity also have to be zero and we do not consider the value of $\varepsilon_{zz}$ component because it does not contribute to deformation energy due to assumption of $\sigma_{zz} = 0$.

To simplify formulas engineering notations of a components of strain tensor $\varepsilon_{xy}$ will be used and vector $\varepsilon$ with components $\varepsilon_x = \varepsilon_{xx}, \varepsilon_y = \varepsilon_{yy}, \gamma_{xy} = 2 *\varepsilon_{xy}$ and vector $\sigma$ with components $\sigma_x = \sigma_{xx}, \sigma_y = \sigma_{yy}, \tau_{xy} = \sigma_{xy}$ (actually from transformation point of view they are not vectors) is introduced. Using that notations Hooke's law is written in the form:

$$\sigma_i(x,y) = \sum_k H_{ik}\varepsilon_k(x,y) \qquad (3)$$
$$\sigma = \mathbf{H}\varepsilon$$

Young's modulus is denoted as $E$, Poisson's ratio as $\mu$ that in an isotropic case yields:

$$\mathbf{H} = E/(1-\mu^2)\begin{bmatrix} 1 & \mu & 0 \\ \mu & 1 & 0 \\ 0 & 0 & \frac{1}{2}(1-\mu) \end{bmatrix} \qquad (4)$$

The mask displacement field can be presented as a vector function

$$u(x,y) = \begin{bmatrix} \Delta x(x,y) \\ \Delta y(x,y) \end{bmatrix}$$

Infinitesimal strain tensor field can be derived from displacement field using Cauchy formulas. In vector form it is written as:

$$\varepsilon(x,y) = \mathbf{A}\, u(x,y) \qquad (5)$$

Where matrix operator A is constructed from partial derivative elements:

$$\mathbf{A} = \begin{bmatrix} \partial/\partial x & 0 \\ 0 & \partial/\partial y \\ \partial/\partial y & \partial/\partial x \end{bmatrix} \qquad (6)$$

We will use Lagrange variational principle for the potential energy of the mask.
Potential energy of the deformation in our notations can be written as:

$$P = \int P(x,y,z)dV \qquad (7)$$

In 2D approximation it does not depend on z :

$$P(x,y) = 1/2(\sigma_x \varepsilon_x + \sigma_y \varepsilon_y + \tau_{xy}\gamma_{xy}) = 1/2(\sigma,\varepsilon) \qquad (8)$$

Substituting strain field using Hooke's law in form (3) one will get:

$$P(x,y) = \frac{1}{2}(\mathbf{H}\varepsilon,\varepsilon)$$

Expressing deformation potential energy via displacement vector field inside element $\alpha$ one will get:

$$P^{\alpha}(x,y) = \frac{1}{2}\big(\mathbf{H}\mathbf{A}(u-w^{\alpha}), \mathbf{A}(u-w^{\alpha})\big) \qquad (9)$$

$$P = \sum_{\alpha} \int_{\alpha} P^{\alpha}(x,y)dV$$

$$P^\alpha = \int_\alpha P^\alpha(x,y)dV$$

This is a key statement of this approach. Due to the fact that every element after writing has new equilibrium shape in expression for the potential energy we have to count displacement from it's equilibrium.

So $w^\alpha(x,y)$ is a vector field that describes a new equilibrium shape of element $\alpha$.

$$w^\alpha(x,y) = \begin{bmatrix} x^\alpha_e(x,y) \\ y^\alpha_e(x,y) \end{bmatrix}$$

For every element according to finite element approach we present vector fields $u(x,y)$ and $w^\alpha(x,y)$ as a linear interpolation of vertices(corner) values of displacements.

Coordinates x and y are still global coordinates, but functions $u(x, y)$ and $w^\alpha(x,y)$ are already approximated as linear combination of their values at the corners of the element

$$N_2 \quad N_3$$

$$N_0 \quad N_1$$

$$u(x,y) = N_0 u_0 + N_1 u_1 + N_2 u_2 + N_3 u_3$$

$$w^\alpha(x,y) = N_0 w^\alpha_0 + N_1 w^\alpha_1 + N_2 w^\alpha_2 + N_3 w^\alpha_3$$

$$N_0(x,y) = \frac{(x_1 - x)}{(x_1 - x_0)} \frac{(y_1 - y)}{(y_1 - y_0)} \quad N_1(x,y) = \frac{(x - x_1)}{(x_1 - x_0)} \frac{(y_1 - y)}{(y_1 - y_0)}$$

$$N_2(x,y) = \frac{(x_1 - x)}{(x_1 - x_0)} \frac{(y - y_0)}{(y_1 - y_0)} \quad N_3(x,y) = \frac{(x - x_1)}{(x_1 - x_0)} \frac{(y - y_0)}{(y_1 - y_0)}$$

This will give good continuous approximation of real displacement field $u(x,y)$.

Hence potential energy of deformation can be expressed as linear combination of the displacement values that are defined on a rectangular grid of our elements.

Variational Lagrange principle states that equilibrium position of a body has minimum of potential energy and any partial variation over every displacement is equal to zero. In our case it leads to a linear equation.

Let us introduce vectors of corners displacements.

$$
\upsilon^{\alpha} =
\begin{bmatrix}
\Delta x(x_0, y_0) \\
\Delta y(x_0, y_0) \\
\Delta x(x_1, y_1) \\
\Delta y(x_1, y_1) \\
\Delta x(x_2, y_2) \\
\Delta y(x_2, y_2) \\
\Delta x(x_3, y_3) \\
\Delta y(x_3, y_3)
\end{bmatrix}
\qquad
\omega^{\alpha} =
\begin{bmatrix}
x^{\alpha}{}_e(x_0, y_0) \\
y^{\alpha}{}_e(x_0, y_0) \\
x^{\alpha}{}_e(x_1, y_1) \\
y^{\alpha}{}_e(x_1, y_1) \\
x^{\alpha}{}_e(x_2, y_2) \\
y^{\alpha}{}_e(x_2, y_2) \\
x^{\alpha}{}_e(x_3, y_3) \\
y^{\alpha}{}_e(x_3, y_3)
\end{bmatrix}
$$

Let us skip not important arithmetic manipulations and express variation of potential energy of deformation of element $\alpha$.

$$
\delta P^{\alpha} / \delta \upsilon^{\alpha} = Y\upsilon^{\alpha} - Y\omega^{\alpha}
$$

To express variation of all the potential energy of the deformation in this notations we will do global enumeration of the elements and nodes from left to right by rows from bottom to top.

So every grid node $\xi$ will have left neighbor $\xi$-1, right neighbor $\xi$ +1, lower neighbor $\xi$ - $M$ and upper neighbor $\xi$ + $M$. Every element will numerate according to number of it's left bottom node.

The 3D problem can be solved in the same way but will take more computational resources.

It is a further task to correct not only the registration correction but also the errors occurring when performing the overlay of multiple lithographic layers. This means registration as printed on a wafer taking into account errors that may be introduced by scanner stage and optics. Registration is not translated directly to the overlay problem because working with a lithographic scanner scaling and ortho correction is used.

It is evident that the features mentioned above and those mentioned below, which are yet to be explained, can be used not only in the combinations mentioned, but also in any other combinations, or alone, without departing from the scope of the present invention.

The invention will be explained in more detail below, by way of example and with reference to the enclosed Figures, which also disclose essential features of the invention.

The following figures present:

Fig. 1: A mask with one registration error of 10 nm;

Fig. 2: Determined Pixel densities to be applied. Arbitrary units from the lightest to the darkest shading are used representing a range from 0 to 0.92% attenuation;

Fig. 3: Resulting registration changes, same units as in Fig. 1;

Fig. 4: Resulting registration error, same units as in Fig. 1, the maximum registration error being 4.5nm.

The different writing modes are realized by changing one or more of the writing parameters. This is done in the following way: For changing the laser pulse power e the state of a beam attenuator that always exists in the known systems is adjusted or the RF power of an AOD (Acoustic-optical device) that is a main part of known pixel writing tools is adjusted Using an AOD the pulse power can be controlled for every pixel.

Change of beam divergence is done by selection of different writing objectives or by special optical designs of groups of optical elements that control beam magnification. The different objectives can be quickly changed using an exchanging turret.

Pulse duration can be controlled as a further parameter.

The amount of pulses per single pixel can easily be adjusted. On the known system for every writing pixel we can generate high repetition rate burst of pulses and that allows to decrease breakdown threshold to 20-30%.

Writing with different polarization of the beam is implemented with a rotating half lambda wave plate to control polarization plane or a rotating quarter lambda wave plate to control polarization ellipticity. The fast way to control polarization is to introduce an electro optical crystal driven by electrical power.

Writing with different beam astigmatism is implemented using a long focal distance cylindrical lens which is rotated or removed it in order to get the desired beam astigmatism. This also can be done by tilting one of the further lenses used the optical path. A further way to do it is to use an adaptive mirror, controlled for example by piezo actuators.

In a preferred embodiment the correction of the registration is performed using the following method:

1. Specify set of the writing modes that will be used for registration correction.

2. For every writing mode one has to define resulting modification of element equilibrium shape and it's elastic properties (equivalent of CDC ratio). That can be done also by analysis of the resulting registration change for test writings.

3. Specify the area of the writing and elements that cover of the area. Pixels can only be written in areas without patterns (in the frame of the mask) or only in active areas with patterns, or in combination of them or any other area of the mask.

4. Describe constraints of the writing. For example in case of simultaneous CD and registration correction in the active area the pixel shade density is defined by the CD map. In case of only registration correction it might be a constant value of pixel shade density in the active area. In the frame area one may want to limit amplitude of the writing with some safety value not to destroy the material of the mask.

5. In case of overlay correction one may add optimization variables, describing ortho and/or scaling transformations.

6. Define target functional ( that can be deviation from registration change or deviation from target registration or target overlay) .

7. Write the pixels as determined.

A mask already corrected by writing pixels can be corrected again if necessary. Then preferably pixels have to be written in different layers. Different layers are defined at planes within the mask parallel to the surface of the mask.

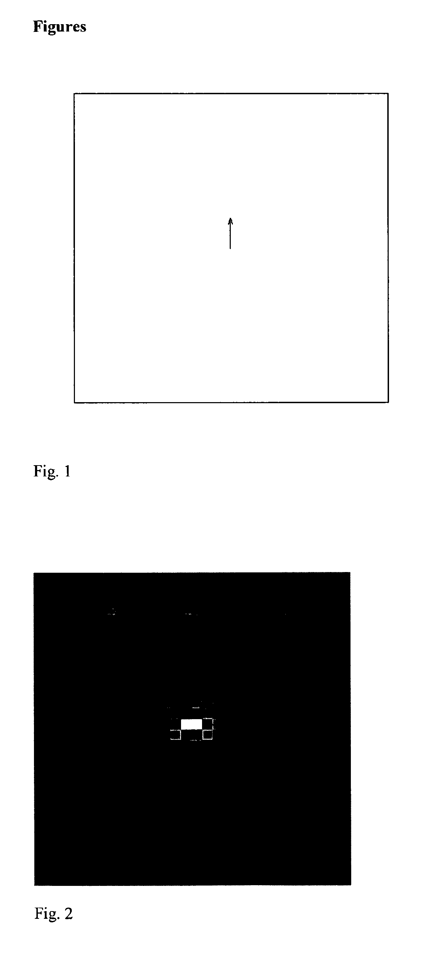

As an example of the registration correction we start from a mask with one registration error of 10 nm as shown in Fig. 1 by an arrow. The length of the arrow is proportional to the size of the error. The starting point of the arrow is the position of the correct place of the structural element of the pattern (the pattern is not shown here). The end of the arrow marks the real position of the structural element to be corrected.

For this correction two different writing modes are used. The first writing mode does not change registration, the second makes x-y symmetric expansion.

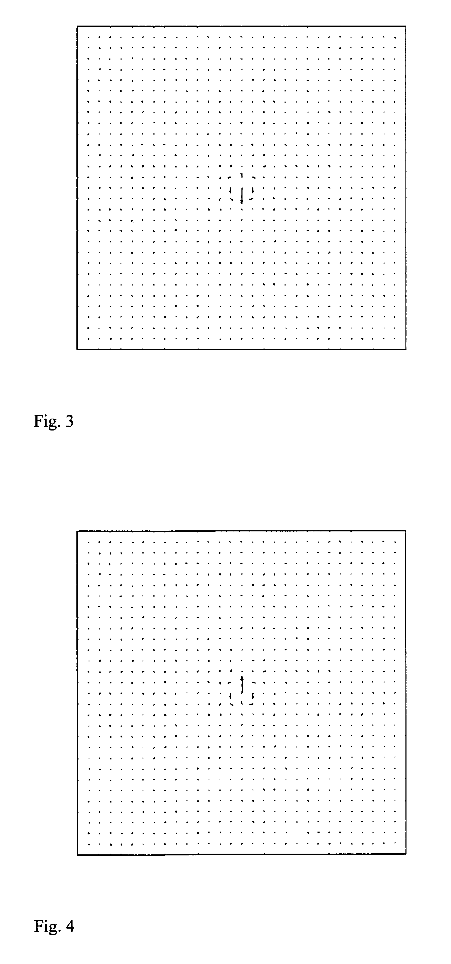

Fig.2 represents the determined Pixel densities to be applied within the elements. Fig. 3 represents the resulting registration changes. Fig. 4 presents the resulting registration errors, the maximum registration error being 4.5nm.

For writing the pixels an apparatus as disclosed in the European patent application EP1649323 is used.

**Claims**

1. A method for correcting registration errors of a mask, the mask comprising a surface and structural elements forming a pattern located on the surface,
   the method comprising:

   measuring the registration errors of the structural elements
   partitioning the mask in arbitrary elements
   determining for each element a writing mode and a density of pixels for minimization of the registration errors,
   writing the determined pixels for correcting the registration error.

2. The method as claimed in claim 1, wherein one or more of the following parameters for writing the pixels in different writing modes will be changed:

   laser pulse power; laser beam polarization, beam astigmatism.

3. The method as claimed in claim 1, wherein the pixels written in the different writing modes differ in one or more of the following parameters:

   pixel size, pixel shape, distance of the pixels from the surface, number of layers of pixels, overlap of pixels, different linear pixel density or different pixel overlap in different perpendicular directions parallel to the surface of the reticle.

4. The method as claimed in claim 3, wherein the pixel shape is variable in an expansion ratio parallel to the surface of the mask.

5. The method as claimed in anyone of the previous claims comprising the further step of measuring the change of the shape of an element for the different writing modes.

6. The method as claimed in anyone of the previous claims wherein the determination of the writing mode and the density of pixels comprises using the Moving Least Squares metod or by converting the discreet parameters of the writing modes to continuous analog parameters.

7. The method as claimed in anyone of the previous claims comprising the further step of the elements each having a the shape of a rectangular parallelepiped and all having the same size.

8. The method as claimed in anyone of the previous claims adding a condition that for each element the density of pixels is equal and only the writing mode varies avoiding changes of the transmission of the mask, i. e. avoiding changes of critical dimensions.

9. The method as claimed in anyone of the previous claims adding a condition that critical dimension is corrected simultaneously with registration determining writing modes and pixel densities causing the required transmission changes and registration changes.

10. The method as claimed in anyone of the previous claims adding a condition that pixels are written only in areas without patterns.

11. The method as claimed in anyone of the previous claims adding the condition that taking errors that are introduced by a scanner and/or a stage and/or optics used during a lithographic process will be taken into account determining the writing mode and the density of pixels.

12. Apparatus for performing the method as claimed in anyone of the previous claims.

**Figures**

Fig. 1

Fig. 2

Fig. 3

Fig. 4

Europäisches
Patentamt

European
Patent Office

Office européen
des brevets

## EUROPEAN SEARCH REPORT

Application Number

EP 09 00 0560

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| D,X | DE 10 2006 054820 A1 (ADVANCED MASK TECHNOLOGY CT GM [DE]; QIMONDA AG [DE]) 29 May 2008 (2008-05-29) * the whole document * | 1-12 | INV. G03F1/00 G03F1/14 G03F7/00 |
| D,X | US 2008/032206 A1 (LEE MYOUNG-SOO [KR] ET AL) 7 February 2008 (2008-02-07) * the whole document * | 1-5,12 | |
| X | US 6 404 481 B1 (FELDMAN MARTIN [US] ET AL) 11 June 2002 (2002-06-11) * claim 1 * * column 2, line 56 - column 4, line 44 * | 1-3,7,12 | |
| A | US 2007/065729 A1 (ZAIT EITAN [IL] ET AL) 22 March 2007 (2007-03-22) * the whole document * | 1-12 | |
| A | US 2004/041102 A1 (KAMM FRANK-MICHAEL [DE]) 4 March 2004 (2004-03-04) * claim 1; figures 1-3 * * paragraphs [0012] - [0033] * | 1-12 | TECHNICAL FIELDS SEARCHED (IPC) G03F |
| A | DATABASE INSPEC [Online] THE INSTITUTION OF ELECTRICAL ENGINEERS, STEVENAGE, GB; February 2007 (2007-02), GOTTLIEB G ET AL: "Correcting ACLV by mask substrate tuning" XP002520124 Database accession no. 9354747 * the whole document * -/-- | 1-12 | |

The present search report has been drawn up for all claims

| Place of search | Date of completion of the search | Examiner |
|---|---|---|
| Munich | 20 March 2009 | von Hentig, Tanja |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

| | Europäisches Patentamt European Patent Office Office européen des brevets | **EUROPEAN SEARCH REPORT** | Application Number EP 09 00 0560 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| | -& GIDI GOTTLIEB ET AL: "Correcting ACLV by mask substrate tuning" MICROLITHOGRAPHY WORLD, vol. 16, no. 1, February 2007 (2007-02), pages 10-12, XP002520122 Pennwell Publishing Corp. USA ISSN: 1074-407X * the whole document * ----- | | |
| A | MORIKAWA Y ET AL: "In-field CD uniformity control by altering transmission distribution of the photomask using ultra-fast pulsed laser technology" PROCEEDINGS OF THE SPIE - THE INTERNATIONAL SOCIETY FOR OPTICAL ENGINEERING SPIE-INT. SOC. OPT. ENG USA, vol. 6283, no. 1, 18 April 2006 (2006-04-18), pages 62831Y-1, XP002520123 ISSN: 0277-786X * the whole document * ----- | 1-12 | TECHNICAL FIELDS SEARCHED (IPC) |

The present search report has been drawn up for all claims

| Place of search | Date of completion of the search | Examiner |
|---|---|---|
| Munich | 20 March 2009 | von Hentig, Tanja |

EPO FORM 1503 03.82 (P04C01)

**ANNEX TO THE EUROPEAN SEARCH REPORT
ON EUROPEAN PATENT APPLICATION NO.**                    EP 09 00 0560

This annex lists the patent family members relating to the patent documents cited in the above-mentioned European search report.
The members are as contained in the European Patent Office EDP file on
The European Patent Office is in no way liable for these particulars which are merely given for the purpose of information.

20-03-2009

| Patent document cited in search report | Publication date | Patent family member(s) | | Publication date |
|---|---|---|---|---|
| DE 102006054820 A1 | 29-05-2008 | NONE | | |
| US 2008032206 A1 | 07-02-2008 | CN | 101122737 A | 13-02-2008 |
| | | KR | 100791338 B1 | 03-01-2008 |
| US 6404481 B1 | 11-06-2002 | NONE | | |
| US 2007065729 A1 | 22-03-2007 | NONE | | |
| US 2004041102 A1 | 04-03-2004 | DE | 10239858 A1 | 11-03-2004 |
| | | NL | 1024199 C1 | 02-03-2004 |

For more details about this annex : see Official Journal of the European Patent Office, No. 12/82

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 102006054820
- US 2008032206 A
- EP 1649323 A